(19) Europäisches Patentamt
European Patent Office
Office européen des brevets

(11) **EP 4 362 649 A1**

(12) **EUROPEAN PATENT APPLICATION**
published in accordance with Art. 153(4) EPC

(43) Date of publication:
**01.05.2024 Bulletin 2024/18**

(21) Application number: **22869851.0**

(22) Date of filing: **06.09.2022**

(51) International Patent Classification (IPC):
**H10N 30/853** (2023.01)    **H10N 30/045** (2023.01)
**H10N 30/076** (2023.01)    **H10N 30/20** (2023.01)

(52) Cooperative Patent Classification (CPC):
**H10N 30/1051; H10N 30/8554;** H10N 30/076

(86) International application number:
**PCT/JP2022/033376**

(87) International publication number:
**WO 2023/042704 (23.03.2023 Gazette 2023/12)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **16.09.2021 JP 2021150811**

(71) Applicant: **KONICA MINOLTA, INC.**
**Tokyo 100-7015 (JP)**

(72) Inventors:
• **MATSUSHITA, Yuji**
**Tokyo 100-7015 (JP)**
• **HARA, Shintaro**
**Tokyo 100-7015 (JP)**
• **MASHIMA, Hideki**
**Tokyo 100-7015 (JP)**

(74) Representative: **Gille Hrabal**
**Partnerschaftsgesellschaft mbB**
**Patentanwälte**
**Brucknerstraße 20**
**40593 Düsseldorf (DE)**

(54) **PIEZOELECTRIC ELEMENT, PIEZOELECTRIC ACTUATOR, LIQUID DROPLET DISCHARGING HEAD, LIQUID DROPLET DISCHARGING DEVICE, AND FERROELECTRIC MEMORY**

(57)     An object of the present invention is to provide a piezoelectric element having a higher electromechanical coupling coefficient, and a piezoelectric actuator, a droplet discharge head, a liquid droplet ejection apparatus, and a ferroelectric memory, these having the piezoelectric element.

A piezoelectric element of the present invention is characterized in that the piezoelectric element includes a first electrode, a second electrode, and a lead zirconate titanate film located between the first electrode and the second electrode, wherein the piezoelectric element is formed on a Si substrate whose principal surface is (001) plane, the Si substrate has uniform crystalline orientation in an in-plane direction and an out-of-plane direction, (110) plane of the Si substrate and (100) plane of the lead zirconate titanate film are parallel, in a rocking curve measurement of an X-ray diffraction method, symmetric surface reflection peak of the lead zirconate titanate film obtained by X-rays incident from [100] direction of the Si substrate can be fitted with three component peaks.

FIG .11

**Description**

Technical Field

The present invention relates to a piezoelectric element, a piezoelectric actuator, a droplet discharge head, a liquid droplet ejection apparatus, and a ferroelectric memory.

More specifically, the present invention relates to a piezoelectric element etc. having a higher electromechanical coupling coefficient.

Background Art

A piezoelectric element using a PZT (lead zirconate titanate: $Pb(Zr,Ti)O_3$) as a piezoelectric body has widely been used. Further, in order to obtain a piezoelectric element having higher piezoelectric properties, a technique of, for example, epitaxial growth/epitaxy of a PZT to obtain a single-crystal PZT film has been developed.

For example, Patent Document 1 discloses a ferroelectric thin film element formed by epitaxial growth/epitaxy of a PZT on a silicon substrate, (TiA1)N thin film or $SrRuO_3$ thin film. In addition, Patent Document 2 discloses a film structure formed by epitaxial growth/epitaxy of a PZT on a silicon substrate, $ZrO_2$ film, Pt film, or $SrRuO_3$ film.

However, even in a piezoelectric element formed by epitaxial growth/epitaxy of a PZT using the above-described technique, an electromechanical coupling coefficient as an index of piezoelectric properties is not sufficient, and a piezoelectric element having a higher electromechanical coupling coefficient has been required.

Citation List

Patent Literature

[Patent Document 1] JP 2000-91533 A
[Patent Document 2] JP 2019-216181 A

Summary of the Invention

Problem to be Solved by the Invention

The present invention has been made in view of the above problems and circumstances, and an object of the present invention is to provide a piezoelectric element having a higher electromechanical coupling coefficient, and a piezoelectric actuator, a droplet discharge head, a liquid droplet ejection apparatus, and a ferroelectric memory, these having the piezoelectric element.

Means for Solving the Problem

In order to solve the above problem, the present inventors studied the causes and the like of the above problem, and found that in a piezoelectric element including a first electrode, a second electrode, and a lead zirconate titanate film (hereinafter, also referred to as "a PZT film") located between the first electrode and the second electrode, (110) plane of a Si substrate or a Pt electrode and (100) plane of the PZT film are parallel to each other, and the PZT film is formed so that symmetric surface reflection peak of the PZT film obtained by an X-ray incident from [100] direction of the Si substrate or the Pt electrode can be fitted with three component peaks in a rocking curve measurement of an X-ray diffraction method, thereby providing a piezoelectric element or the like having a higher electromechanical coupling coefficient.

That is, the above-described problem according to the present invention is solved by the following means.

1. A piezoelectric element including a first electrode, a second electrode, and a lead zirconate titanate film located between the first electrode and the second electrode, wherein

the piezoelectric element is formed on a Si substrate whose principal surface is (001) plane,
the Si substrate has uniform crystalline orientation in an in-plane direction and an out-of-plane direction,
(110) plane of the Si substrate and (100) plane of the lead zirconate titanate film are parallel,
in a rocking curve measurement of an X-ray diffraction method, symmetric surface reflection peak of the lead zirconate titanate film obtained by X-rays incident from [100] direction of the Si substrate can be fitted with three component peaks.

2. A piezoelectric element including a first electrode, a second electrode, and a lead zirconate titanate film located between the first electrode and the second electrode, wherein

at least one of the first electrode and the second electrode includes a Pt electrode whose principal surface is (001) plane,
the Pt electrode has uniform crystalline orientation in an in-plane direction and an out-of-plane direction,
(110) plane of the Pt electrode and (100) plane of the lead zirconate titanate film are parallel,
in a rocking curve measurement of an X-ray diffraction method, symmetric surface reflection peak of the lead zirconate titanate film obtained by X-rays incident from [100] direction of the Pt electrode can be fitted with three component peaks.

3. The piezoelectric element according to item 1, wherein an angle of a plane angle formed by (001) plane of the Si substrate and (001) plane of the lead zirconate titanate film is in the range of 0.34 to 0.35°.
4. The piezoelectric element according to item 2, wherein an angle of a plane angle formed by (001) plane of the Pt electrode and (001) plane of the lead zirconate titanate film is in the range of 0.34 to 0.35°.
5. The piezoelectric element according to item 1 or 3, wherein an angle of a plane angle formed by (100) plane of the Si substrate and (100) plane of the lead zirconate titanate film is in the range of 40 to 50°.
6. The piezoelectric element according to item 2 or 4, wherein an angle of a plane angle formed by (100) plane of the Pt electrode and (100) plane of the lead zirconate titanate film form is in the range of 40 to 50°.
7. The piezoelectric element according to any one of items 1 to 6, wherein a diffraction peak of (004) plane of the lead zirconate titanate film obtained by out-of-plane $2\theta$-$\omega$ scanning of an X-ray diffraction method can be fitted with three component peaks.
8. The piezoelectric element according to any one of items 1 to 7, wherein the composition of lead zirconate titanate constituting the lead zirconate titanate film is $Pb_X(Zr_Y, Ti_{1-Y})O_3$ [$1.0 \leq X \leq 1.2$, $0.4 \leq Y \leq 0.6$]
9. The piezoelectric element according to any one of items 1 to 8, wherein a thickness of the lead zirconate titanate film is in the range of 0.1-5.0 $\mu$m.
10. The piezoelectric element according to any one of items 1 to 9, wherein at the interface between the second electrode and the lead zirconate titanate film, a dielectric film composed of a dielectric having a dielectric constant lower than that of lead zirconate titanate constituting the lead zirconate titanate film is present, and the dielectric film and the lead zirconate titanate film have epitaxial relations such that (100) plane of the dielectric film and (100) plane of the lead zirconate titanate film are parallel.
11. The piezoelectric element according to item 10, wherein the dielectric is lanthanum lead titanate.
12. The piezoelectric element according to item 10 or 11, wherein the total thickness of the lead zirconate titanate film and the dielectric film is in the range of 0.1 to 5.0 $\mu$m.
13. The piezoelectric element according to any one of items 10 to 12, wherein a RMS value of surface roughness of the dielectric film at the side of the second electrode is 5.0nm or less.
14. The piezoelectric element according to any one of items 1 to 13, wherein when the piezoelectric constant measured by grounding the first electrode and applying a voltage of 30V to the second electrode is A and the piezoelectric constant measured by applying a voltage of 10V to the second electrode is B, B is 95% or more of A.
15. A piezoelectric actuator including a piezoelectric element, wherein the piezoelectric element is a piezoelectric element according to any one of items 1 to 14.
16. A droplet discharge head including a piezoelectric actuator, wherein the piezoelectric actuator is a piezoelectric actuator according to item 15.
17. A liquid droplet ejection apparatus including a droplet discharge head, wherein the droplet discharge head is a droplet discharge head according to item 16.
18. A ferroelectric memory including a piezoelectric element, wherein the piezoelectric element is a piezoelectric element according to any one of items 1 to 14.

Effect of the Invention

According to the above means, a piezoelectric element having a higher electromechanical coupling coefficient and a piezoelectric actuator, a droplet discharge head, a liquid droplet ejection apparatus, and a ferroelectric memory, these having the piezoelectric element can be provided.
The expression mechanism or action mechanism of the effects of the present invention has not been clarified, but it is presumed as follows.

(110) plane of Si substrate or Pt electrode and (100) plane of PZT film are parallel, and in a rocking curve measurement of an X-ray diffraction method, symmetric surface reflection peak of the PZT film obtained by X-rays incident from [100] direction of the Si substrate or the Pt electrode can be fitted with 3 component peaks means the crystalline phase of the PZT film is a mixed crystal of a monoclinic phase and a rhombohedral phase, and the PZT film is not an oriented film but an epitaxial film.

Here, "an oriented film" refers to a film in which the crystallographic orientation is aligned in the out-of-plane direction, but is randomly oriented in the in-plane direction, and is also referred to as "an uniaxial oriented film". "an epitaxial film" refers to a film in which the crystallographic orientation is aligned both in the out-of-plane direction and the in-plane direction. The epitaxial film is formed by growing crystals in a particular orientation based on the regularity of the atomic arrangement of the crystals in the underlying layers. This growth is called, epitaxial growth/epitaxy. The relationship between a film of epitaxial growth/epitaxy and a film or the like constituting the layers on which epitaxial growth/epitaxy is based is referred to as "epitaxial relationship".

In an oriented film, since the polarization in the plane is randomly oriented, the polarization is rotated with respect to the application of the electric field, and the dielectric constant becomes large. On the other hand, since the epitaxial film is a single domain, the polarization is less likely to be rotated with respect to the application of the electric field, and the dielectric constant become small. However, since the remanent polarizations are high in the epitaxial film, it is possible to have a high piezoelectric constant though the dielectric constant is low.

An electromechanical coupling coefficient, which is an index of piezoelectric properties, is obtained by the following equation (1).

[Mathematical equation 1]

$$k_{31,f}{}^2 = \frac{d_{31,f}{}^2}{\varepsilon \times s} \times 100 \quad \cdot \cdot \cdot \text{EQUATION}(1)$$

$k_{31,f}{}^2$: Electromechanical coupling coefficient [%]
$d_{31,f}$: Piezoelectric constant [m/V]
$\varepsilon$ : Dielectric constant [F/m]
$s$ : Elastic compliance[$m^2$/N]

As can be seen from this equation, the higher the piezoelectric constant and the lower the dielectric constant, the higher an electromechanical coupling coefficient. Therefore, a piezoelectric element in which a PZT film is an epitaxial film has a higher electromechanical coupling coefficient than that of a piezoelectric element in which a PZT film is an oriented film.

In piezoelectric elements disclosed in Patent Documents 1 and 2, though a PZT film is an epitaxial film, (001) plane of a Si substrate and (001) plane of a PZT film are parallel to each other. In contrast, a piezoelectric element of the present invention has a configuration in which (001) plane of a PZT film is not parallel to (001) plane of a Si substrate or the like, as can be seen from the fact that the peak of symmetric surface reflection described above can be fitted with three component peaks. Due to this difference, a piezoelectric element of the present invention is different from the conventional piezoelectric element in crystalline phases of a PZT film, and it can obtain a higher electromechanical coupling coefficient.

These expression mechanisms or action mechanisms can provide a piezoelectric element or the like having a higher electromechanical coupling coefficient.

Brief Description of the Drawings

[FIG. 1] Schematic cross-section view of a piezoelectric element
[FIG. 2] Schematic view of a sample for measurement of the piezoelectric constant
[FIG. 3] Schematic view of a measuring device for the piezoelectric constant
[FIG. 4] Result of out-of-plane XRD measurement of a piezoelectric element No. 1
[FIG. 5] Result (magnified) of out-of-plane XRD measurement of a piezoelectric element No. 1
[FIG. 6] Fitting curve when fitting a peak derived from (004) plane of a PZT film of a piezoelectric element No. 1 with one component peak
[FIG. 7] Fitting curve when fitting a peak derived from (004) plane of a PZT film of a piezoelectric element No. 1 with three component peaks
[FIG. 8] Result of in-plane XRD measurement of a piezoelectric element No. 1

[FIG. 9] Fitting curve when fitting symmetric surface reflection peak of RC measurement of a piezoelectric element No. 1 with one component peak

[FIG. 10] Fitting curve when fitting symmetric surface reflection peak of RC measurement of a piezoelectric element No. 1 with two component peaks

[FIG. 11] Fitting curve when fitting symmetric surface reflection peak of RC measurement of a piezoelectric element No. 1 with three component peaks

[FIG. 12] Result of out-of-plane XRD measurement of a piezoelectric element No. 2

[FIG. 13] Result (magnified) of out-of-plane XRD measurement of a piezoelectric element No. 2

[FIG. 14] Fitting curve when fitting a peak derived from (004) plane of a PZT film of a piezoelectric element No. 2 with one component peak

[FIG. 15] Result of in-plane XRD measurement of a piezoelectric element No. 2

[FIG. 16] Fitting curve when fitting symmetric surface reflection peak of RC measurement of a piezoelectric element No. 2 with one component peak

[FIG. 17] Atomic force microscope image of a PLT film of a piezoelectric element No. 1

[FIG. 18] Atomic force microscope image of a PLT film of a piezoelectric element No. 2

Mode for Carrying out the Invention

A piezoelectric element of the present invention is characterized in that, as an embodiment, the piezoelectric element includes a first electrode, a second electrode, and a lead zirconate titanate film located between the first electrode and the second electrode, wherein the piezoelectric element is formed on a Si substrate whose principal surface is (001) plane, the Si substrate has uniform crystalline orientation in an in-plane direction and an out-of-plane direction, (110) plane of the Si substrate and (100) plane of the lead zirconate titanate film are parallel, in a rocking curve measurement of an X-ray diffraction method, symmetric surface reflection peak of the lead zirconate titanate film obtained by X-rays incident from [100] direction of the Si substrate can be fitted with three component peaks.

Further, a piezoelectric element of the present invention is characterized in that, as an embodiment, the piezoelectric element includes a first electrode, a second electrode, and a lead zirconate titanate film located between the first electrode and the second electrode, wherein at least one of the first electrode and the second electrode includes a Pt electrode whose principal surface is (001) plane, the Pt electrode has uniform crystalline orientation in an in-plane direction and an out-of-plane direction, (110) plane of the Pt electrode and (100) plane of the lead zirconate titanate film are parallel, in a rocking curve measurement of an X-ray diffraction method, symmetric surface reflection peak of the lead zirconate titanate film obtained by X-rays incident from [100] direction of the Pt electrode can be fitted with three component peaks.

These features are technical features common to or corresponding to embodiments below.

In an embodiment of a piezoelectric element of the present invention, the angle formed by (001) plane of the Si substrate or the Pt electrode and (001) plane of the lead zirconate titanate film is preferably in the range of 0.34 to 0.35°, from the viewpoint of crystalline structure.

In an embodiment of a piezoelectric element of the present invention, the angle formed by (100) plane of the Si substrate or the Pt electrode and (100) plane of the lead zirconate titanate film is preferably in the range of 40° to 50°, from the viewpoint of crystalline structure.

In an embodiment of a piezoelectric element of the present disclosure, it is preferable from the viewpoint of crystalline structure that a diffraction peak of (004) plane of the lead zirconate titanate film obtained by out-of-plane $2\theta$-$\omega$ scanning of an X-ray diffraction method can be fitted with three component peaks.

In an embodiment of a piezoelectric element of the present invention, from the viewpoint of the piezoelectric constant, it is preferable that the composition of lead zirconate titanate constituting the lead zirconate titanate film has a $Pb_X(Zr_Y, Ti_{1-Y})O_3$ [$1.0 \leq X \leq 1.2$, $0.4 \leq Y \leq 0.6$].

In an embodiment of a piezoelectric element of the present invention, the thickness of the lead zirconate titanate film is preferably in the range of 0.1 to 5.0 μm. As a result, the displacement-generating force required for a piezoelectric element can be obtained.

In an embodiment of a piezoelectric element of the present invention, it is preferable that at the interface between the second electrode and the lead zirconate titanate film, a dielectric film composed of a dielectric having a dielectric constant lower than that of lead zirconate titanate constituting the lead zirconate titanate film is present, and the dielectric film and the lead zirconate titanate film have epitaxial relations such that (100) plane of the dielectric film and (100) plane of the lead zirconate titanate film are parallel. As a result, the dielectric constant can be lowered, and an electromechanical coupling coefficient can be further improved.

In an embodiment of a piezoelectric element of the present invention, from the viewpoint of dielectric constant, it is preferable that the dielectric is lanthanum lead titanate.

In an embodiment of a piezoelectric element of the present invention, the total thickness of the lead zirconate titanate film and the dielectric film is preferably in the range of 0.1 to 5.0µm. As a result, the displacement-generating force required for a piezoelectric element can be obtained.

In an embodiment of a piezoelectric element of the present invention, a RMS value of surface roughness of the dielectric film at the side of the second electrode is preferably 5.0nm or less. This improves reliability in long-term driving, adhesion of film, and the like.

In an embodiment of a piezoelectric element of the present invention, from the viewpoint of linearity of the piezoelectric constant, it is preferable that when the piezoelectric constant measured by grounding the first electrode and applying a voltage of 30V to the second electrode is A and the piezoelectric constant measured by applying a voltage of 10V to the second electrode is B, B is 95% or more of A.

A piezoelectric actuator of the present invention is a piezoelectric actuator including a piezoelectric element, wherein the piezoelectric element is a piezoelectric element of the present invention.

A droplet discharge head of the present invention is a droplet discharge head including a piezoelectric actuator, wherein the piezoelectric actuator is a piezoelectric actuator of the present invention.

A liquid droplet ejection apparatus of the present invention is a liquid droplet ejection apparatus including a droplet discharge head, wherein the droplet discharge head is a droplet discharge head of the present invention.

A ferroelectric memory of the present invention is a ferroelectric memory including a piezoelectric element, wherein the piezoelectric element is a piezoelectric element of the present invention.

Hereinafter, the present invention, its constituent elements, and embodiments and aspects for carrying out the present invention will be described in detail. In the present application, "to" is used in the meaning that numerical values described before and after are included as a lower limit value and an upper limit value.

<1. Summary of a piezoelectric element of the present invention>

A piezoelectric element of the present invention is characterized in that, as an embodiment, the piezoelectric element includes a first electrode, a second electrode, and a PZT film located between the first electrode and the second electrode, wherein the piezoelectric element is formed on a Si substrate whose principal surface is (001) plane, the Si substrate has uniform crystalline orientation in an in-plane direction and an out-of-plane direction, (110) plane of the Si substrate and (100) plane of the PZT film are parallel, in a rocking curve measurement of an X-ray diffraction method, symmetric surface reflection peak of the lead zirconate titanate (PZT) film obtained by X-rays incident from [100] direction of the Si substrate can be fitted with three component peaks.

Further, a piezoelectric element of the present invention is characterized in that, as an embodiment, the piezoelectric element includes a first electrode, a second electrode, and a PZT film located between the first electrode and the second electrode, wherein at least one of the first electrode and the second electrode includes a Pt electrode whose principal surface is (001) plane, the Pt electrode has uniform crystalline orientation in an in-plane direction and an out-of-plane direction, (110) plane of the Pt electrode and (100) plane of the PZT film are parallel, in a rocking curve measurement of an X-ray diffraction method, symmetric surface reflection peak of the lead zirconate titanate (PZT) film obtained by X-rays incident from [100] direction of the Pt electrode can be fitted with three component peaks.

The PZT film or the like included in the piezoelectric element is composed of crystals. In the present invention, the "crystal plane" and the "crystal orientation" of the crystal are expressed using the Miller index (Miller index). A crystal is a collection of unit lattices, which are formed by a collection of planes made up of atoms. The plane made by these atoms is called a "crystal plane". In addition, although the crystal planes are arranged at equal intervals in parallel with each other, a direction of arrangement of the crystal planes (a direction perpendicular to the crystal plane) is referred to as a "crystal orientation". Crystal planes are denoted as (100) planes, (110) planes, etc. using the plane indexes of the Miller index. Further, the crystal orientation is expressed as [100] direction or the like by using the direction index (orientation index) of the Miller index.

As a reference of the Miller index in the present invention, the out-of-plane direction, which is the normal direction of the principal surface of Si substrate, is defined as [001] direction, and the direction perpendicular to (100) plane or (010) plane among the in-plane direction, which is the direction parallel to the principal surface of a Si substrate, is defined as [100] direction or [010] direction, respectively. [100] orientation and [010] orientation are indistinguishable because Si is cubic phase and rotationally symmetric. In addition, when the relation with a Pt electrode is defined instead of Si substrate, similarly, the out-of-plane direction, which is the normal direction of the principal surface of a Pt electrode, is defined as [001] direction, and the direction perpendicular to (100) plane or (010) plane among the in-plane direction, which is the direction parallel to the principal surface of a Pt electrode, is defined as [100] direction or [010] direction, respectively. Since Pt is also rotationally symmetric in the plane, [100] direction and [010] direction are indistinguishable.

<2. Configuration of a piezoelectric element>

A piezoelectric element of the present invention includes a first electrode, a second electrode, and a PZT film located between the first electrode and the second electrode.

A piezoelectric element of the present invention is preferably formed on a Si substrate whose principal surface is (001) plane. However, after the PZT film or the like is made of film, the Si substrate can be removed and used, and therefore, a piezoelectric element of the present invention is not limited to those formed on the Si substrate.

Here, a "principal surface" in the present invention means a surface having the largest surface area.

Materials of the first electrode and the second electrode are not particularly limited, and Cr, Ni, Cu, Pt, Ir, Ti, Ir-Ti alloy, $LaNiO_3$, SRO ($SrRuO_3$), STO($SrTiO_3$), or the like can be used. The first electrode may be formed by two or more electrodes. Similarly, the second electrode may be formed by two or more electrodes.

At least one of the first electrode and the second electrode preferably includes a Pt electrode, and the Pt electrode preferably has (001) plane as a principal surface and preferably has an uniform crystalline orientation in an in-plane direction and an out-of-plane direction. When one of the first electrode and the second electrode includes a Pt electrode, the other electrode is preferably a Cu electrode.

The first electrode or the second electrode including a Pt electrode is preferably a two-layer structure further including an electrode made of another material. The electrode made of another material may be an SRO electrode or an STO electrode, and is more preferably a SRO electrode. Like the Pt electrode, the electrodes made of other materials preferably have uniform crystalline orientation in an in-plane direction and an out-of-plane direction.

In a PZT film according to the present invention, the composition of PZT is preferably $Pb_X(Zr_Y, Ti_{1-Y})O_3$ [$1.0 \leq X \leq 1.2$, $0.4 \leq Y \leq 0.6$] in terms of the piezoelectric constant.

In a piezoelectric element of the present invention, it is preferable that a dielectric film formed of a dielectric material having a dielectric constant lower than that of a PZT constituting a PZT film is present at the interface between the second electrode and the PZT film. As a result, the dielectric constant can be lowered, and an electromechanical coupling coefficient can be further improved. The crystalline structure of the dielectric constituting the dielectric film is preferably a perovskite-type structure. Examples of the dielectric having a perovskite-type structure include lead titanate ($PbTiO_3$), lanthanum lead titanate (PLT:(Pb,La)$TiO_3$, and barium titanate ($BaTiO_3$). Among these, those containing lead are preferred, and PLT is particularly preferred from the viewpoint of the dielectric constant.

A piezoelectric element of the present invention may have another layer, for example, a $ZrO_2$ layer or a $HfO_2$ layer between the Si substrate and the first electrode.

A preferred configuration of a piezoelectric element of the present invention will be described below. The configuration of a piezoelectric element of the present invention is not limited thereto.

(1) Second electrode/dielectric film (PLT film)/PZT film/first electrode (SRO electrode + Pt electrode)/$ZrO_2$ layer /Si substrate

(2) Second electrode/dielectric film (PLT film)/PZT film/first electrode (SRO electrode + Pt electrode)/$HfO_2$ layer /Si substrate

(3) Second electrode/dielectric film (PLT film)/PZT film/first electrode (STO electrode + Pt electrode)/$ZrO_2$ layer /Si substrate

(4) Second electrode/dielectric film (PLT film)/PZT film/first electrode (STO electrode + Pt electrode)/$HfO_2$ layer /Si substrate

(5) Second electrode/dielectric film (PLT film)/PZT film/first electrode (SRO electrode + Pt electrode)/$ZrO_2$ layer

(6) Second electrode /PZT film/Second electrode (SRO electrode + Pt electrode)/$ZrO_2$ layers /Si substrate

(7) Second electrode/dielectric film (PLT film)/PZT film/first electrode (Pt electrode)/$ZrO_2$ layer /Si substrate

(8) Second electrode/dielectric film (PLT film)/PZT film/first electrode (SRO electrode + Pt electrode)/Si substrate

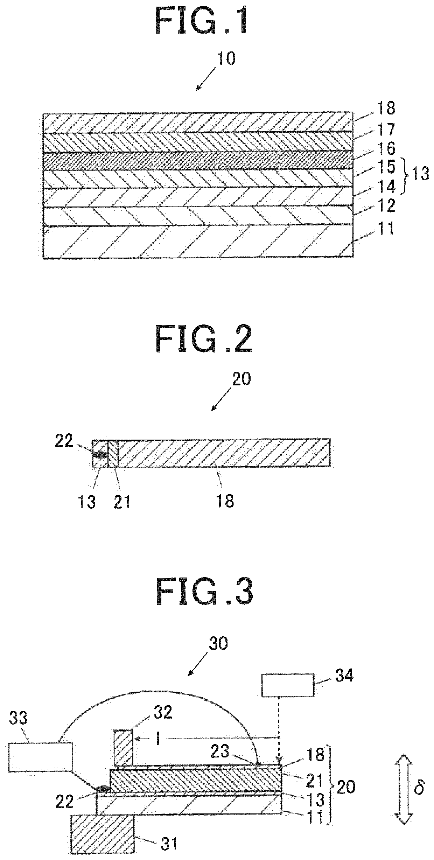

Among configuration examples mentioned above, the configuration (1) is particularly preferable. FIG. 1 is a schematic cross-sectional view of a a piezoelectric element having the configuration (1). A piezoelectric element 10 shown in FIG. 1 is formed by laminating a $ZrO_2$ layer 12, a first electrode 13(Pt electrode 14, and a SRO electrode 15), a PZT film 16, a dielectric film 17, and a second electrode 18 on a Si substrate 11.

In a piezoelectric element of the present invention, the thickness of a PZT film is preferably in the range of 0.1 to 5.0 $\mu$m. When a dielectric film is provided, the combined thickness of the PZT film and the dielectric film is preferably 0.1 to 5.0$\mu$m. As a result, the displacement-generating force required for a piezoelectric element is obtained.

<3. Crystalline structure>

A piezoelectric element of the present invention is characterized in that (110) plane of a Si substrate or a Pt electrode is parallel to (100) plane of a PZT film. When (110) plane of a Si substrate or a Pt electrode and (100) plane of a PZT film are parallel to each other, epitaxial growth/epitaxy of a PZT film is performed, and an epitaxial strain received from the layers below the PZT film (for example, SRO layers) becomes a tensile strain from a compressive strain, so that a mixed crystal of a monoclinic phase and a rhombohedral phase is stabilized and a higher piezoelectric constant is obtained. In addition, since the PZT film becomes an epitaxial film, the dielectric constant of the epitaxial film becomes lower than that of an oriented film, and thus an electromechanical coupling coefficient can be increased.

In the present invention, "(110) plane of a Si substrate and (100) plane of a PZT film are parallel" means that when X-rays are incident from [110] direction of a Si substrate in the in-plane measuring of XRD (X-ray diffraction) method, a diffraction peak of (H00) plane of the PZT film is obtained. Similarly, "(110) plane of a Pt electrode and (100) plane of a PZT film are parallel" means that when X-rays are incident from [110] direction of a Pt electrode in the in-plane measurement of X-ray diffraction method, a diffraction peak of (H00) plane of the PZT film is obtained.

In a piezoelectric element of the present invention, an angle of a plane angle formed by (100) plane of the Si substrate and (100) plane of the PZT film is preferably in the range of 40 to 50°, from the view point of crystalline structure.

An angle of a plane angle which (100) plane of a Si substrate and (100) plane of a PZT film form can be confirmed from a diffraction peak of (H00) plane of a PZT film when X-rays are incident from [110] direction of a Si substrate or a Pt electrode in an in-plane measurement of X-ray diffraction method.

In addition, in a piezoelectric element having a dielectric film, it is preferable that (100) plane of the dielectric film and (100) plane of the PZT film are in epitaxial relation.

The epitaxial relation in which (100) plane of the dielectric film and (100) plane of the PZT film are parallel can be confirmed from the fact that, in an in-plane measurement of X-ray diffraction method, when X-rays are incident from [110] direction of the Si substrate or the Pt electrode, a diffraction peak of (H00) plane of the PZT film and a diffraction peak of (H00) plane of the dielectric film are obtained.

A piezoelectric element of the present invention is characterized in that, in a rocking curve measurement of an X-ray diffraction method, symmetric surface reflection peak of a PZT film obtained by X-ray incident from [100] direction of a Si substrate or a Pt electrode can be fitted with three component peaks. A PZT film satisfying the above-mentioned conditions has a monoclinic phase and a rhombohedral phase, and therefore a higher piezoelectric constant is obtained. In addition, since the PZT film becomes an epitaxial film, the dielectric constant of the PZT film becomes lower than that of an oriented film, and thus an electromechanical coupling coefficient can be increased.

In the present invention, the phrase "can be fitted with three component peaks" means that when fitting is performed while increasing the number of component peaks under the fitting condition described below, there are three component peaks whose determination factor $R^2$ does not become larger than that.

(Fitting Conditions)

A Symmetric Pseudo Voigt probability-density-distribution function, which is a mixture of a Lorentz function and a Gaussian function, is adopted for the fitting function. The function f is expressed by the following equation (2).
[Mathematical equation 2]

$$f_{(x)} = I * \left( \eta \, \frac{1}{1 + \left(\frac{2(x - x_0)}{h_l}\right)^2} + (1 - \eta) \sqrt{\pi \ln 2} \exp\left(-\left(\frac{2(x - x_0)}{h_g}\right)^2\right) \right)$$

$$\cdots \text{ EQUATION(2)}$$

In equation (2), I represents peak intensity, $\eta$ represents a ratio of a Lorentz function to a Gaussian function, $h_l$, $h_g$ represents half-width, and $x_0$ represents peak position. The combination of a plurality of peaks is given by the sum of respective distribution functions. Each peak on which the combination is based is referred to as a "component peak" in the present invention.

The determination factor $R^2$ is defined by the following equation (3).
[Mathematical equation 3]

$$R^2 = 1 - \frac{\sum_{i=1}^{N}(y_i - f_i)^2}{\sum_{i=1}^{N}(y_i - \bar{y})^2} \quad \cdots \text{ EQUATION(3)}$$

In equation (3), yi = $\{y_1, \cdots y_N\}$: observation point, y-bar: mean of observation point, fi = $\{f_1, \cdots f_N\}$: presumed value.

In a piezoelectric element of the present invention, an angle of a plane angle formed by (001) plane of a Si substrate or a Pt electrode and (001) plane of a PZT film is preferably in the range of 0.34 to 0.35°. In a rocking curve measurement of an X-ray diffraction method, when symmetric surface reflection peak of a PZT film obtained by X-ray incident from [100] direction of a Si substrate or a Pt electrode is fitted with three component peaks, the angle can be obtained from the split-width of each component peak.

Specifically, the difference between $\omega_1$ and $\omega_2$ and the difference between $\omega_2$ and $\omega_3$ are calculated, assuming that the angle (three) at which the peak intensity is maximized at the respective component peaks is $\omega_1$, $\omega_2$, $\omega_3$ from the smaller one. The mean of these two differences (in other words, the value determined by $(\omega_3\text{-}\omega_1)/2$) is an angle of a plane angle formed by (001) plane of the Si substrate or the Pt electrode and (001) plane of the PZT film.

<4. The piezoelectric constant>

In a piezoelectric element of the present invention, from the viewpoint of linearity of the piezoelectric constant, when the piezoelectric constant $d_{31,\,f}$ measured by grounding the first electrode and applying a voltage of 30V to the second electrode is A and the piezoelectric constant $d_{31,\,f}$ measured by applying a voltage of 10V to the second electrode is B, it is preferable that B is 95% or more of A. Further, from the viewpoint of the polarization-maintaining property, when the piezoelectric constant $d_{31,\,f}$ measured by applying a voltage of -20V to the second electrode is C, it is preferable that C is in the range of 40 to 50% of A. When C is in the range of 40 to 50% of A, the depolarization field is moderated and the polarization-maintaining property is improved, suggesting that the ferroelectric is imprinted.

In the present invention, the piezoelectric constant $d_{31,\,f}$ of a piezoelectric element is measured by preparing a sample for measurement and using the sample for measurement. The piezoelectric constant $d_{31,\,f}$ in the present invention refers to the piezoelectric constant obtained by an inverse piezoelectric effect.

The sample for measurement is prepared using a second electrode-free piezoelectric element formed on a Si substrate. The second electrode-free piezoelectric element is cut into strips of 2mm×15mm. Next, 3mm of the longitudinal end portion is masked, and a second electrode such as Cu, Al, Ag is formed to be a film by sputtering or by a vacuum-deposition device. The thickness of the second electrode shall be in the range of 0.05 to 0.2$\mu$m. After removing mask, a part (about 2mm at the end portion) of the portion other than the first electrode where the second electrode is not formed is removed by etching. The first electrode exposed after the etching is coated with Ag paste as a first electrode contact for measurement. The sample for measurement of the piezoelectric constant is prepared by the above procedure.

FIG. 2 is a schematic view of a sample for measurement of the piezoelectric constant viewed from the upper side (a second electrode-side for measurement). The sample 20 for measurement shown in FIG. 2 includes an exposed first electrode 13, a first electrode contact 22 coated on the first electrode 13, an exposed inter-electrode layer 21, and a second electrode 18. Further, although not shown, a Si substrate is provided below the first electrode. Here, the "inter-electrode layer 21" is a layer including a PZT film, a dielectric film, or the like between the first electrode 12 and the second electrode 18.

The sample for measurement is sandwiched between the lower support and the upper support, and one side is restrained in a cantilever shape to be fixed. The position of the restraint point shall be the same as that of the upper support or the lower support, and the distance from the upper restraint point to the other end of the sample for measurement shall be measured to be the length l [m] of the sample for measurement. A lead wire is pulled out from the first electrode contact, the second electrode side for measurement is brought into contact with the tip of the thin wire-like electric wire or the like which does not interfere with the vibration to form a second electrode contact for measurement, and a sine wave formed from a waveform generator is applied between the first electrode and the second electrode for measurement. The frequency for measurement is 500Hz, and the voltage is applied in the range of -30V to +30V, A laser is applied to the end of the sample for measurement which vibrates by applying a waveform, using a Doppler displacement meter, to obtain a signal. By performing Fourier transform or the like on the signal, the displacement amount $\delta$ [m] is calculated.

FIG. 3 is a schematic view of a measuring device viewed from the side. One side of the sample 20 for measurement is fixed by a lower support 31 and an upper support 32. A second electrode contact 23 is in contact with the second electrode 18 of the sample for measurement. A measuring device 30 includes a waveform generator 33 and a Doppler displacement meter 34.

The piezoelectric constant $d_{31,\,f}$ can be obtained using the calculated displacement amount and the following equation (4).

[Mathematical equation 4]

$$\delta = \frac{3d_{31,f}s_1 s_2 t_1 (t_1 + t_2)l^2 V}{s_1^2 t_2^4 + 4s_1 s_2 t_1 t_2^3 + 6s_1 s_2 t_1^2 t_2^2 + 4s_1 s_2 t_1^3 t_2 + s_2^2 t_1^4} \quad \cdots \text{EQUATION(4)}$$

$\delta$ : Displacement amount [m]
$d_{31,\,f}$: the piezoelectric constant [m/V]
l : Sample length for measurement [m]
V : Applied voltage [V]

$s_1$: Elastic Compliance of PZT film [$m^2$/N]
$s_2$: Elastic Compliance of Si substrate [$m^2$/N]
$t_1$ : Distance between electrodes [m]
$t_2$ : Thickness of Si substrate [m]

For the elastic compliance $s_1$ of PZT film, the elastic compliance $s_2$ of Si substrate, values shown in the literature can be adopted.

<5. Surface roughness of Dielectric film>

As described above, a piezoelectric element of the present invention preferably has a dielectric film at the interface between the second electrode and the PZT film. Further, it is preferable that a RMS(root mean square) value of surface roughness of the dielectric film at the side of the second electrode is 5.0nm or less. Further, it is more preferably 2.0nm or less, and even more preferably 1.6nm or less. This improves reliability in long-term driving, adhesion of film, and the like.

The RMS value of surface roughness can be measured, for example, using an atomic force microscope (Dimension Icon manufactured by Bruker Corporation).

<6. Use of a piezoelectric element>

A piezoelectric actuator, a droplet discharge head, a liquid droplet ejection apparatus, and a ferroelectric memory of the present invention are characterized by including a piezoelectric element of the present invention. As long as the piezoelectric actuator or the like includes a piezoelectric element of the present invention, other parts of the piezoelectric actuator or the like are not particularly limited, and they may be configured using a commonly used member.

A piezoelectric element of the present invention can be used in, for example, a piezoelectric microphone, a vibrating sensor, a displacement sensor, an ultrasonic detector, an oscillator, a resonator, a ceramic filter, a piezoelectric transformer, a piezoelectric buzzer, an ultrasonic motor, and the like.

Examples

Hereinafter, the present invention will be described in detail with reference to examples, but the present invention is not limited thereto. In examples, "part" or "%" is used, but unless otherwise specified, "part by mass" or "% by mass" is used.

A piezoelectric element No. 1 (the present invention) and a piezoelectric element No. 2 (comparative example) were prepared, and XRD, surface roughness of a PLT film, and electric properties were measured using these piezoelectric elements. These measurements were carried out under conditions of a temperature of 23°C.

<Preparation of a piezoelectric element No. 1>

For a substrate, an 8-inch substrate (manufactured by KRYSTAL Corporation) composed of each layer in SRO/Pt/$ZrO_2$/Si order was used. In the substrate, a Si layer corresponds to a Si substrate of the present invention. In the substrate, a Pt layer and an SRO layer correspond to the first electrodes composed of two layers of a Pt electrode and an SRO electrode. Each layer of the substrate has uniform crystalline orientation in an in-plane direction and an out-of-plane direction, and the principal surface is (001) plane.

On an SRO layer of the substrate, a PZT film was formed by RF magnetron sputtering method. PZT ceramic target made of a lead-rich composition ($Pb_{1.25}(Zr_{0.52}, Ti_{0.48})O_3$) having a Pb of 25% higher than the stoichiometric composition was used.

The thickness of the PZT film and sputtering conditions are as follows.

| | |
|---|---|
| Thickness | 3.38$\mu$m |
| RF power supply | 3.0 kW |
| Gas flow rate | Ar:$O_2$=39.5:0.5sccm |
| Sputtering pressure | 0.2Pa |
| Substrate setting temp. | 550°C |

In the PZT film forming step described above, the PZT film was formed in two times, and the cleaning was performed between the first and second times.

Next, a dielectric film (PLT film) was formed on the PZT film by RF magnetron sputtering method. PLT ceramic target made of a lead-rich composition $(Pb_{1.125}, La_{0.1})TiO_3$ having a Pb of 25% higher than the stoichiometric composition of Pb:La=0.9:0.1, was used.

The thickness of the dielectric film (PLT film) and sputtering conditions are as follows.

| | |
|---|---|
| Thickness | $0.12\mu m$ |
| RF power supply | 2.0 kW |
| Gas flow rate | Ar:$O_2$=39.5:0.5sccm |
| Sputtering pressure | 0.2Pa |
| Substrate setting temp | 560°C |

A second electrode-free piezoelectric element No. 1 was prepared by the above-described procedure.

<Preparation of a piezoelectric element No. 2>

On an 8-inch Bare-Si wafer (a Si substrate) having (001) plane as the principal surface, a first electrode was formed by RF magnetron sputtering method using a Ir-Ti alloy target.

The thickness of the first electrode and sputtering conditions are as follows.

| | |
|---|---|
| Thickness | $0.12\mu m$ |
| RF power supply | 0.75 kW |
| Gas flow rate· | Ar:$O_2$=38:2sccm |
| Sputtering pressure | 0.2Pa |
| Substrate setting temp. | 350°C |

Next, a dielectric film (PLT film) at the side of the first electrode was formed on the first electrode by RF magnetron sputtering method. PLT ceramic target made of a lead-rich composition $(Pb_{1.125}, La_{0.1})TiO_3$ having a Pb of 25% higher than the stoichiometric composition of Pb:La=0.9:0.1, was used.

The thickness of the dielectric film (PLT film) at the side of the first electrode and sputtering conditions are as follows.

| | |
|---|---|
| Thickness | $0.12\mu m$ |
| RF power supply | 2.0 kW |
| Gas flow rate | Ar:$O_2$=39.5:0.5sccm |
| Sputtering pressure | 0.2Pa |
| Substrate setting temp.·· | 560°C |

Next, a PZT film was formed on the dielectric film at the side of the first electrode by RF magnetron sputtering method. PZT ceramic target made of a lead-rich composition $(Pb_{1.25}(Zr_{0.52}, Ti_{0.48})O_3)$ having a Pb of 25% higher than the stoichiometric composition was used.

The thickness of the PZT film and sputtering conditions are as follows.

| | |
|---|---|
| Thickness | $3.26\mu m$ |
| RF power supply | 3.0 kW |
| Gas flow rate | Ar:$O_2$=39.5:0.5sccm |
| Sputtering pressure | 0.2Pa |
| Substrate setting temp. | 550°C |

Next, a dielectric film (PLT film) was formed on the PZT film by RF magnetron sputtering method. PLT ceramic target made of a lead-rich composition $(Pb_{1.125}, La_{0.1})TiO_3$ having a Pb of 25% higher than the stoichiometric composition of Pb:La=0.9:0.1, was used.

The thickness of the dielectric film (PLT film) and sputtering conditions are as follows.

| Thickness | 0.12μm |
|---|---|
| RF power supply | 2.0 kW |
| Gas flow rate | Ar:$O_2$=39.5:0.5sccm |
| Sputtering pressure | 0.2Pa |
| Substrate setting temp. | 560°C |

A second electrode-free piezoelectric element No. 2 was prepared by the above-described procedure.

<XRD measurement of a piezoelectric element No. 1>

A second electrode-free piezoelectric element No. 1 was subjected to an out-of-plane XRD measurement (out-of-plane 2θ-ω scanning) under the following conditions. The out-of-plane measurement was made in the range of 2θ=10-110°. In addition, X-rays entered from [100] direction of a Si substrate.

(Measuring conditions of out-of-plane XRD)

| Measuring device | : SmartLab manufactured by Rigaku Corporation |
|---|---|
| X-ray generator | : Anticathode Cu |
| | : Output 45kV 200mA |
| Detector | : Semiconductor detector |
| Incident optical system: | Ge(220) channel-cut monochromator |
| Solar Slit | : Incident side - |
| | : Receiving side 5.0° |
| Slit | : Incident side IS=1 (mm) |
| | :Longitudinal limit 10(mm) |
| | : Receiving side RS1=1 RS2=1.1(mm) |
| Scanning conditions | : Scanning axis 2θ/ω |
| | : Scanning mode continuous scanning |
| | : Scanning range 10 to 110° |
| | : Step width 0.024° |
| | : Scanning rate 2°/min |

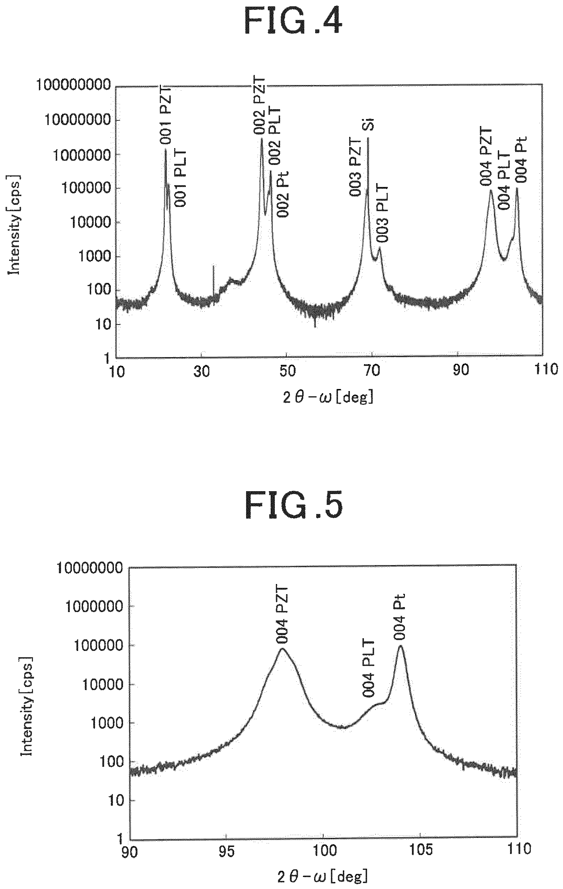

Measuring result of the out-of-plane XRD of a piezoelectric element No. 1 is shown in FIG. 4. From FIG. 4, 00L preferred orientation of the PZT film and the PLT film was confirmed. Here, focusing on a diffraction peak of (004) plane seen at 2θ=90 to 110°, and enlarging the horizontal axis to 2θ=90 to 110°, FIG. 5 mentioned below is obtained.

From FIG. 5, it was confirmed that a diffraction peak of (004) plane of the PZT film around 2θ=98° is not a single peak but peaks in which a plurality of peaks are superimposed.

The peaks derived from (004) plane of the PZT film around 2θ=98° were fitted under the above-described conditions.

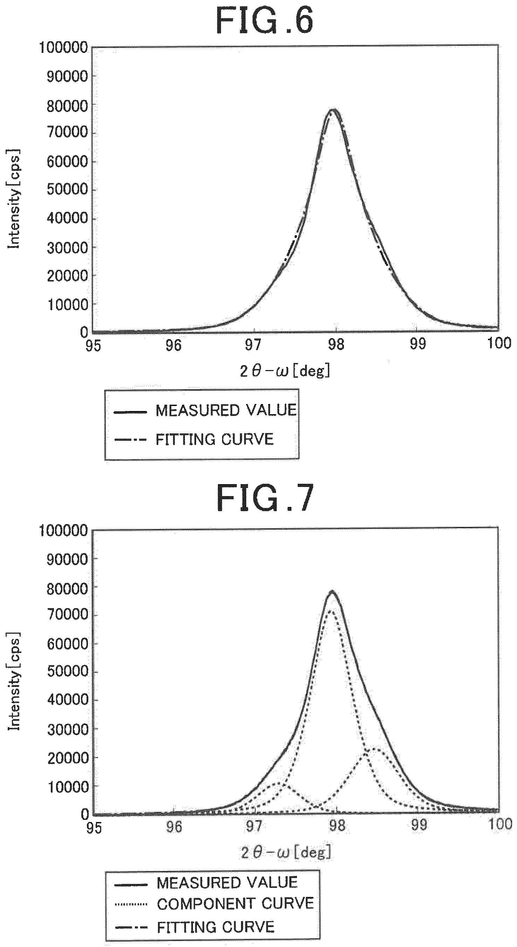

When fitting was performed with one component peak, it is shown in FIG. 6, and the determination factor was $R^2$=0.997724. On the other hand, when fitting was performed with three component peaks, the determination factor was $R^2$=0.999931 as shown in FIG. 7. In addition, fitting with four or more component peaks was divided into the same peaks or did not show an increase in the determination factor. From the above, it was confirmed that a diffraction peak of (004) plane of the PZT film can be fitted with three component peaks of 2θ=97.28°, 97.94°, and 98.47°.

Subsequently, a second electrode-free piezoelectric element No. 1 was subjected to an in-plane XRD measurement under the following conditions. Here, the X-rays entered from [110] direction of the Si substrate. The measurement was made in the range of 2θ=10-110°.

(Measuring conditions of in-plane XRD)

| Measuring device | : SmartLab manufactured by Rigaku Corporation |
|---|---|
| X-ray generator | : Anticathode Cu |

(continued)

|  | : Output 45kV 200mA |
| Detector | : Semiconductor detector |
| Solar Slit | : Incident side Vertical divergence angle 0.5° |
|  | : Receiving side Vertical divergence angle 0.5° |
| Slit | : Incident side TS=0.1 (mm) |
|  | : Longitudinal limit 10(mm) |
|  | : Receiving side RS1=20 RS2=20.1(mm) |
| Scanning conditions | : Scanning axis $2\theta\chi/\varphi$ |
|  | : Incident angle $\omega$ 0.60° |
|  | : Scanning mode continuous scanning |
|  | : Scanning range 10 to 110° |
|  | : Step width 0.024° |
|  | : Scanning rate 2°/min |

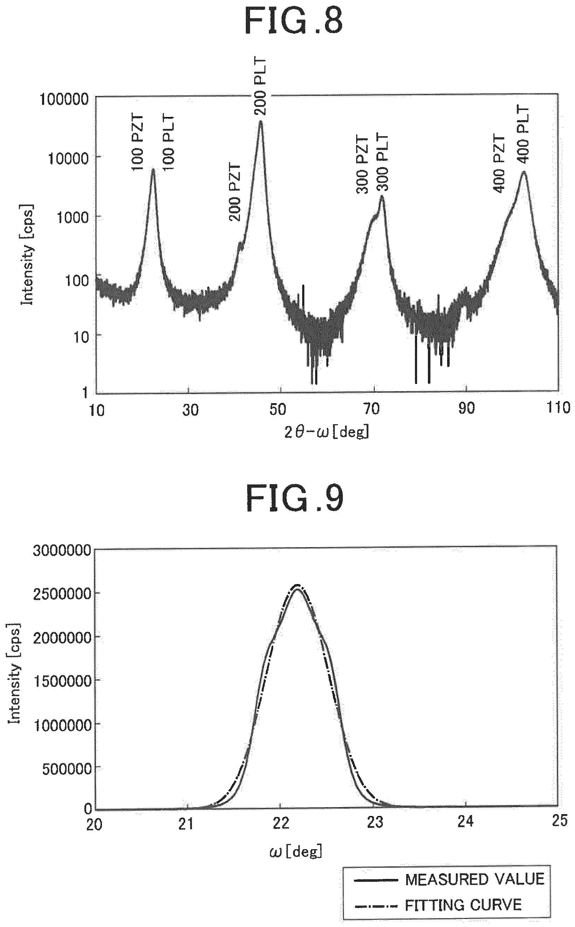

Measuring result of the in-plane XRD of a piezoelectric element No. 1 is shown in FIG. 8. It was confirmed that (110) plane of the Si substrate and (100) plane of the PZT film were parallel to each other, as shown in FIG. 8, when X-rays were incident so as to be parallel to (110) plane of the Si substrate and a diffraction peak of (H00) plane of the PZT film was obtained. Further, since (110) plane of the Si substrate and (110) plane of the Pt electrode are parallel, it can be seen that (110) plane of the Pt electrode and (100) plane of the PZT film are parallel.

In addition, since a diffraction peak of (H00) plane of the PZT film was seen in FIG. 8, it was confirmed that an angle of a plane angle formed by (100) plane of the Si substrate and (100) plane of the PZT film is 45°. Further, since (100) plane of the Si substrate and (100) plane of the Pt electrode are parallel, it can be seen that an angle of a plane angle formed by (100) plane of the Pt electrode and (100) plane of the PZT film is 45°.

In addition, in FIG. 8, it was also confirmed that (100) plane of the PLT film and (100) plane of the PZT film were parallel and in epitaxial relation because a diffraction peak of (H00) plane of the PZT film and a diffraction peak of (H00) plane of the PLT film were respectively confirmed.

A rocking curve (RC) measurement was performed at 002 grid point reflections ($2\theta=44.3°$) of the PZT film under the following conditions.

(Conditions of a rocking curve measurement)

| Measuring device | : SmartLab manufactured by Rigaku Corporation |
| X-ray generator | : Anticathode Cu |
|  | : Output 45kV 200mA |
| Detector | : Semiconductor detector |
| Injection optical system | : Ge(220) channel-cut monochromator |
| Solar Slit | : Incident side - |
|  | : Receiving side 5.0° |
| Slit | : Incident side IS=1(mm) |
|  | : Longitudinal limit 10(mm) |
|  | : Receiving side RS1=1 RS2=1.1(mm) |
| Scanning conditions | : Evaluated diffraction surface PZT(002) |
|  | : Scanning axis $\omega$ |
|  | : Scanning mode continuous scanning |
|  | : Scanning range 10 to 30° |

:Step width 0.024°

(continued)

:Scanning rate 2°/min

Peaks obtained by a rocking curve measurement were fitted under the above-described conditions.

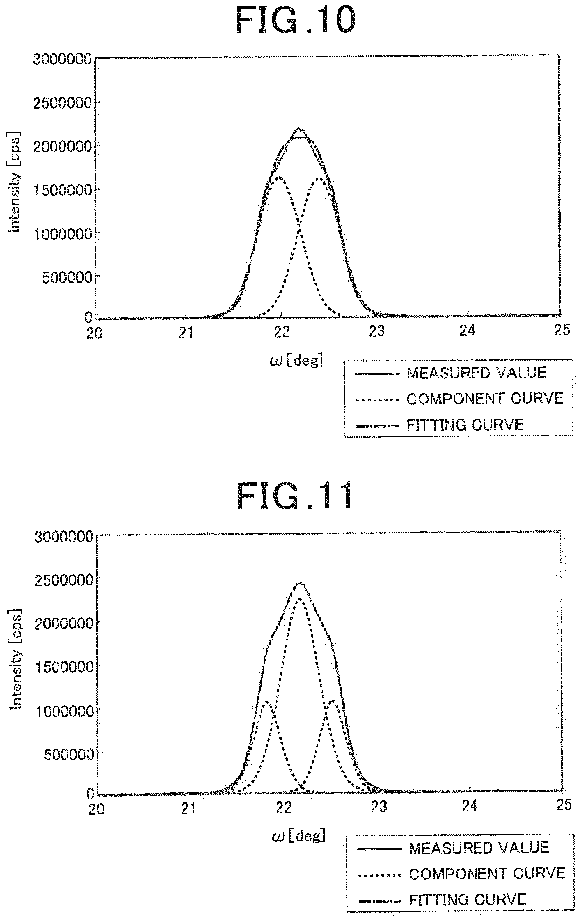

When fitting is performed with one component peak, it was a graph shown in FIG. 9, and the determination factor was $R^2=0.992506$. When fitting was performed with two component peaks, a graph shown in FIG. 10 was obtained, and the determination factor was $R^2=0.997887$. When fitting was performed with three component peaks, a graph shown in FIG. 11 was obtained, and the determination factor was $R^2=0.999929$. Fitting with four or more component peaks was either split into the same peaks as fitting with three component peaks or did not show an increase in the determination factor.

From the above result, in a rocking curve measurement of an X-ray diffraction method, it was confirmed that symmetric surface reflection peaks of the PZT film obtained by X-rays incident from [100] directions of the Si substrate and the Pt electrode could be fitted with three component peaks.

Further, from the split width of each component peak when fitting was performed with the three component peaks, it was confirmed that an angle of a plane angle formed by (001) plane of the Si substrate and (001) plane of the lead zirconate titanate film was 0.35°.

From the result of the above XRD measurement, it was confirmed that a crystalline structure of the PZT film of a piezoelectric element No. 1 was mixed crystals of a monoclinic phase and a rhombohedral phase.

<XRD measurement of a piezoelectric element No. 2>

A second electrode-free piezoelectric element No. 2 was subjected to an out-of-plane XRD measurement (out-of-plane $2\theta-\omega$ scanning) under the same conditions as described above. The out-of-plane measurement was made in the range of $2\theta=10-110°$. In addition, X-rays entered from [100] direction of the Si substrate.

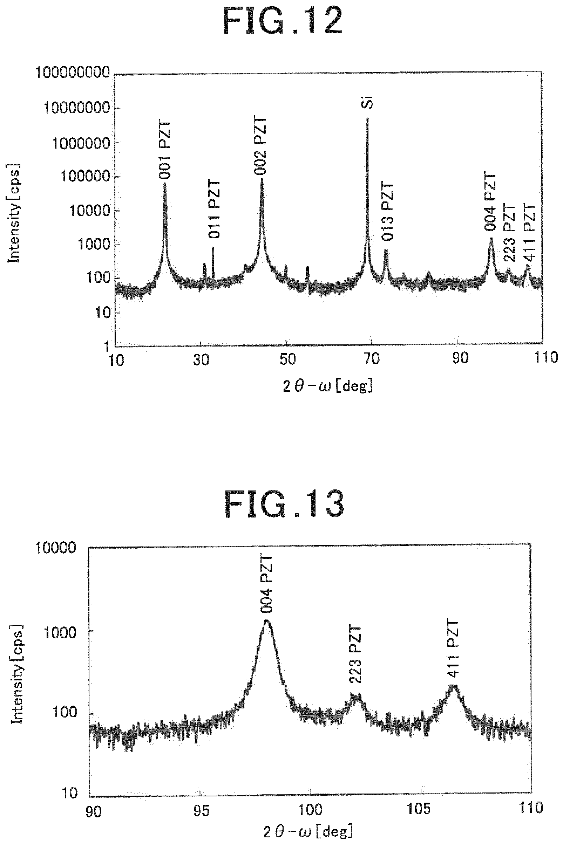

Measurement result of the out-of-plane XRD of a piezoelectric element No. 2 is shown in FIG. 12. From FIG. 12, 00L preferred orientation of the PZT film was confirmed. Here, focusing on a diffraction peak of (004) plane seen at $2\theta=90$ to 110°, and enlarging the horizontal axis to $2\theta=90$ to 110°, FIG. 13 mentioned below is obtained.

In addition, fitting was performed under the same conditions as described above with respect to the peaks derived from (004) plane of the PZT film at around $2\theta=98°$.

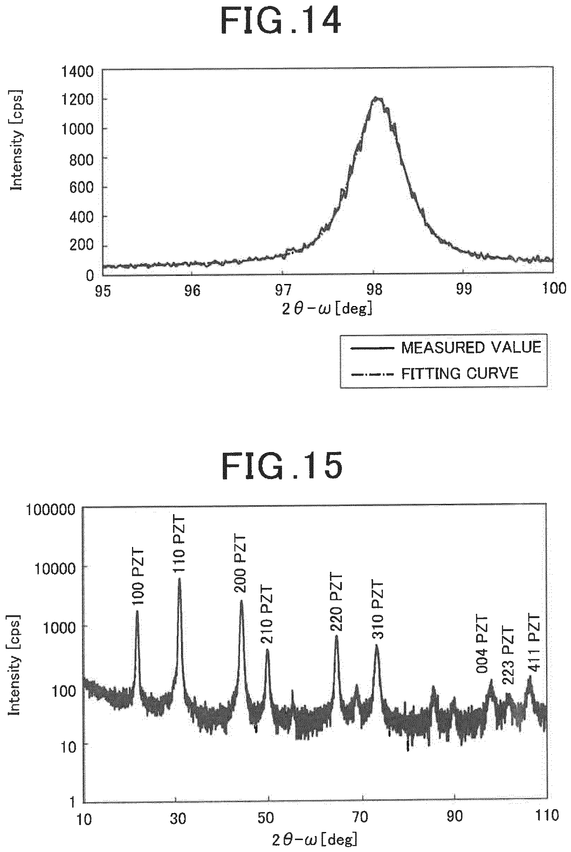

When fitting was performed with one component peak, it is a graph shown in FIG. 14, and the determination factor was $R^2=0.99559$. Further, no increase in the determination factor was observed even if the number of component peaks was increased further. From the above, it was confirmed that a diffraction peak of (004) plane is a single-peak.

Subsequently, the second electrode-free piezoelectric element No. 2 was subjected to an in-plane XRD measurement under the same conditions as described above.

Measurement result of the in-plane XRD of a piezoelectric element No. 2 is shown in FIG. 15. From the result shown in FIG. 15, it was confirmed that peaks derived from polycrystals were obtained and the crystals were random in the in-plane direction. From the above, it was confirmed that the PZT film of a piezoelectric element No. 2 is an oriented film in which the crystals are aligned in the out-of-plane direction but are randomly arranged in the in-plane direction.

A rocking curve measurement was performed at a 001 grid point reflections ($2\theta=21.74°$) of the PZT film under the same conditions as described above. The incidence was performed from [100] orientation of the Si substrate.

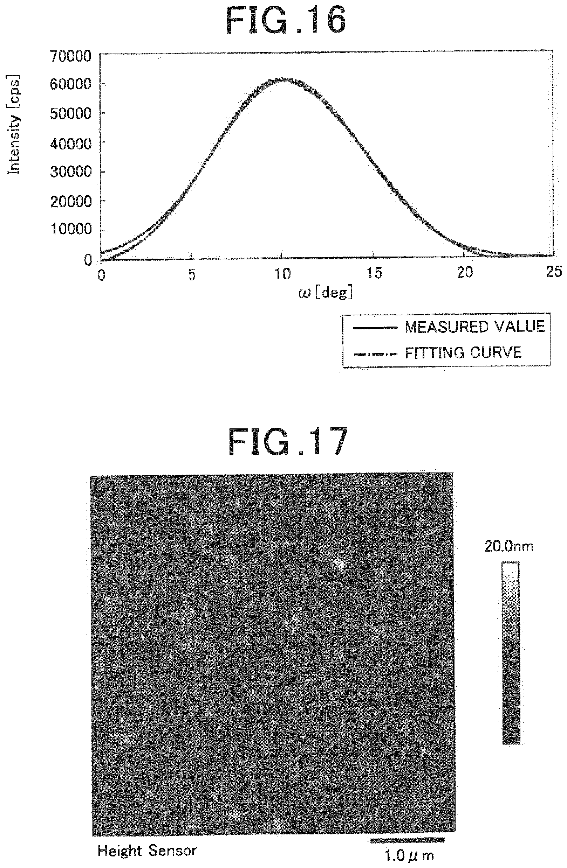

Peaks obtained by the rocking curve measurement were fitted under the same conditions as described above. As a result, when fitting with one component peak, the determination factor was the largest, and $R^2=0.92402$ was obtained. FIG. 16 shows a graph when fitting was performed with one component peak.

From the result of the above XRD measurement, it was confirmed that a crystalline structure of the PZT film of a piezoelectric element No. 2 was a tetragonal phase.

<Measurement of surface roughness of PLT film>

Surface roughness of a PLT film of each second electrode-free piezoelectric element was measured using an atomic force microscope (Dimension Icon manufactured by Bruker Corporation).

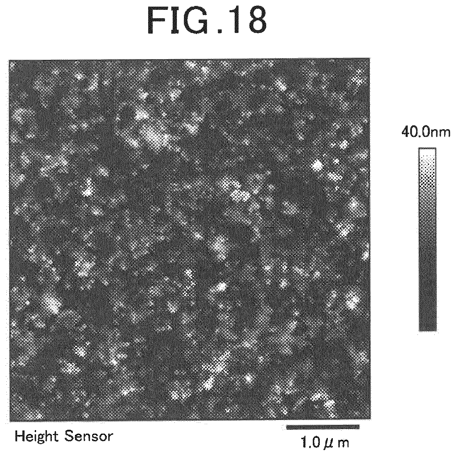

FIG. 17 shows an atomic force microscopic image of a PLT film of a piezoelectric element No. 1. The RMS value of surface roughness for the PLT film was 1.49nm. FIG. 18 shows an atomic force microscopic image of a PLT film of a piezoelectric element No. 2. The RMS value of surface roughness for the PLT film was 4.97nm.

<Measurement of dielectric constant $\varepsilon$ and relative dielectric constant $\varepsilon_r$>

A second electrode was formed on each second electrode-free piezoelectric element by a RF magnetron sputtering method using a Cu target.

The thickness of the second electrode and sputtering conditions are as follows.

| | |
|---|---|
| Thickness | $0.1\mu m$ |
| RF power supply | 1 kW |
| Gas flow rate | Ar=50sccm |
| Sputtering pressure | 0.15Pa |
| Substrate setting temp. | room temperature |

The second electrode (Cu electrode) formed above was patterned into a circular shape having an area $0.0314mm^2$ using a metal mask. The capacitance of the piezoelectric element was measured using an LCR meter (IM3523 manufactured by Hioki Electric Co., Ltd.) under the following conditions.

Excitation voltage: 1V
Excitation frequency: 1kHz
Circuit model: Parallel capacitance model
Measurement items: Cp-D

The dielectric constant $\varepsilon$ and the relative dielectric constant $\varepsilon_r$ were obtained from the measured capacitance and the respective values using the following equation (5). The measurement results are shown in Table 1.
[Mathematical equation 5]

$$\varepsilon_r = \frac{\varepsilon}{\varepsilon_0} = \frac{Cd}{\varepsilon_0 S} \quad \cdot \cdot \cdot \text{EQUATION(5)}$$

$\varepsilon$ : Dielectric constant [F/m]
$\varepsilon_0$: Vacuum dielectric constant [F/m]($8{,}85 \times 10^{-12}$ F/m)
$\varepsilon_r$: Relative dielectric constant
C: Capacitance [F]
d: Distance between electrodes [m]
S: Area of electrode [$m^2$]

<Measurement of the piezoelectric constant $d_{31, f}$>

Each second electrode-free piezoelectric element was cut into strips of 2mm×15mm. Next, about 3mm of the longitudinal one-side end portion was masked and formed by a RF magnetron sputtering method using a Cu target.

The thickness of the second electrode and sputtering conditions are as follows.

| | |
|---|---|
| Thickness | 0.1m |
| RF power supply | 1 kW |
| Gas flow rate | Ar=50sccm |
| Sputtering pressure | 0.15Pa |
| Substrate setting temp. | room temperature |

After removing mask, a part (about 2mm at the end portion) of the portion other than the first electrode where the second electrode for measurement is not formed is removed by etching. Then, the first electrode exposed after the etching was coated with Ag paste as a first electrode contact for measurement.

A sample for measurement was prepared by the above-described operation.

Using the prepared sample for measurement, the displacement $\delta$ was calculated by the above-described measurement method, and further, the piezoelectric constant $d_{31, f}$ at the respective applied voltages (-20V, 10V, 20V, 30V) was obtained by using the following equation (4). The sample length 1 for measurement was 19.5mm. The elastic compliance $s_1$ of the PZT film and the elastic compliance $s_2$ of the Si substrate were adopted as values described in the literature (I. Kanno et al., Piezoelectric properties of c-axis oriented Pb(Zr,Ti) O3 thin films, APL 70, 1378 (1997). The calculated results are shown in Table 1.
[Mathematical equation 6]

$$\delta = \frac{3d_{31,f}s_1 s_2 t_1 (t_1 + t_2)l^2 V}{s_1^2 t_2^4 + 4s_1 s_2 t_1 t_2^3 + 6s_1 s_2 t_1^2 t_2^2 + 4s_1 s_2 t_1^3 t_2 + s_2^2 t_1^4} \qquad \cdot \cdot \cdot \text{EQUATION(4)}$$

$\delta$ : Displacement amount [m]

$d_{31,f}$: the piezoelectric constant [m/V]

1 : Sample length for measurement [m]

V : Applied voltage [V]

$s_1$: Elastic Compliance of PZT film [m$^2$/N]

$s_2$: Elastic Compliance of Si substrate [m$^2$/N]

$t_1$ : Distance between electrodes [m]

$t_2$ : Thickness of Si substrate [m]

<Calculation of an electromechanical coupling coefficient $k_{31,f}^2$>

From the measured dielectric constant $\varepsilon$ and the piezoelectric constant $d_{31,f}$ at the time of applying 30V, an electromechanical coupling coefficient $k_{31,f}^2$ was calculated using the following equation (1). The calculation results are shown in Table 1.

[Mathematical equation 7]

$$k_{31,f}^2 = \frac{d_{31,f}^2}{\varepsilon \times s} \times 100 \qquad \cdot \cdot \cdot \text{EQUATION(1)}$$

$k_{31,f}^2$: Electromechanical coupling coefficient [%]

$d_{31,f}$: Piezoelectric constant [m/V]

$\varepsilon$ : Dielectric constant [F/m]

s : Elastic compliance[m$^2$/N]

[Table 1]

TABLE I

| PIEZOELECTRIC ELEMENT NO. | | NO.1 (PRESENT INVENTION) | NO.2 (COMPARATIVE EXAMPLE) |
|---|---|---|---|
| NUMBER OF COMPONENT PEAKS OF DIFFRACTION PEAK OF (004) PLANE | | THREE | ONE |
| NUMBER OF COMPONENT PEAKS OF SYMMETRIC SURFACE REFLECTION PEAK OF RC MEASUREMENT | | THREE | ONE |
| EPITAXIAL FILM OR ORIENTED FILM | | EPITAXIAL FILM | ORIENTED FILM |
| CRYSTALLINE PHASE OF PZT FILM | | MONOCLINIC PHASE/ RHOMBOHEDRAL PHASE | TETRAGONAL PHASE |
| RMS VALUE OF SURFACE ROUGHNESS OF PLT FILM | | 1.49nm | 4.97nm |
| DIELECTRIC CONSTANT $\varepsilon$ | | $5.50 \times 10^{-9}$F/m | $8.82 \times 10^{-9}$F/m |
| RELATIVE DIELECTRIC CONSTANT $\varepsilon$ | | 621.3 | 996.3 |
| PIEZOELECTRIC CONSTANT $d_{31,f}$ | 30V APPLICATION (A) | 164.7pm/V | 188.7pm/V |
| | APPLICATION | 164.6pm/V | 185.7pm/V |
| | APPLICATION (B) | 161.1pm/V | 175.3pm/V |
| | -20V APPLICATION (C) | 79.9pm/V | 175.7pm/V |

(continued)

| PIEZOELECTRIC ELEMENT NO. | | NO.1 (PRESENT INVENTION) | NO.2 (COMPARATIVE EXAMPLE) |
|---|---|---|---|
| RATIO OF PIEZOELECTRIC CONSTANT | (B/A) | 97.8% | 92.9% |
| | $d_{31,f}$ (C/A) | 48.5% | 93.1% |
| ELECTROMECHANICAL COUPLING COEFFICIENT $k_{31,f}^2$ | | 45.69% | 37.38% |

From the evaluation results shown in Table 1, it can be confirmed that a piezoelectric element of the present invention has higher electromechanical coupling coefficient than that of the comparative example. This is because the dielectric constant is significantly lower than that of the comparative example, and the piezoelectric constant can be maintained while the dielectric constant is lower.

Industrial Applicability

The present invention can be applied to a piezoelectric element having a higher electromechanical coupling coefficient, and a piezoelectric actuator, a droplet discharge head, a liquid droplet ejection apparatus, and a ferroelectric memory, these having the piezoelectric element.

Explanation of Reference Numerals

10 Piezoelectric element
11 Si substrate
12 ZrOz layers
13 First electrode
14 Pt electrode
15 SRO electrode
16 PZT film
17 Dielectric film
18 Second electrode
20 Sample for measurement
21 Inter-electrode layer
22 First electrode contact
23 Second electrode contact
30 Measuring device
31 Lower support
32 Upper support
33 Waveform generator
34 Doppler displacement meter

**Claims**

1.  A piezoelectric element comprising a first electrode, a second electrode, and a lead zirconate titanate film located between the first electrode and the second electrode, wherein

the piezoelectric element is formed on a Si substrate whose principal surface is (001) plane,
the Si substrate has uniform crystalline orientation in an in-plane direction and an out-of-plane direction,
(110) plane of the Si substrate and (100) plane of the lead zirconate titanate film are parallel,
in a rocking curve measurement of an X-ray diffraction method, symmetric surface reflection peak of the lead zirconate titanate film obtained by X-rays incident from [100] direction of the Si substrate can be fitted with three component peaks.

2. A piezoelectric element comprising a first electrode, a second electrode, and a lead zirconate titanate film located between the first electrode and the second electrode, wherein

at least one of the first electrode and the second electrode includes a Pt electrode whose principal surface is (001) plane,
the Pt electrode has uniform crystalline orientation in an in-plane direction and an out-of-plane direction,
(110) plane of the Pt electrode and (100) plane of the lead zirconate titanate film are parallel,
in a rocking curve measurement of an X-ray diffraction method, symmetric surface reflection peak of the lead zirconate titanate film obtained by X-rays incident from [100] direction of the Pt electrode can be fitted with three component peaks.

3. The piezoelectric element according to claim 1, wherein an angle of a plane angle formed by (001) plane of the Si substrate and (001) plane of the lead zirconate titanate film is in the range of 0.34 to 0.35°.

4. The piezoelectric element according to claim 2, wherein an angle of a plane angle formed by (001) plane of the Pt electrode and (001) plane of the lead zirconate titanate film is in the range of 0.34 to 0.35°.

5. The piezoelectric element according to claim 1 or 3, wherein an angle of a plane angle formed by (100) plane of the Si substrate and (100) plane of the lead zirconate titanate film is in the range of 40 to 50°.

6. The piezoelectric element according to claim 2 or 4, wherein an angle of a plane angle formed by (100) plane of the Pt electrode and (100) plane of the lead zirconate titanate film is in the range of 40 to 50°.

7. The piezoelectric element according to any one of claims 1 to 6, wherein a diffraction peak of (004) plane of the lead zirconate titanate film obtained by out-of-plane $2\theta$-$\omega$ scanning of an X-ray diffraction method can be fitted with three component peaks.

8. The piezoelectric element according to any one of claims 1 to 7, wherein the composition of lead zirconate titanate constituting the lead zirconate titanate film is $Pb_X(Zr_Y, Ti_{1-Y})O_3$ [$1.0 \leq X \leq 1.2$, $0.4 \leq Y \leq 0.6$]

9. The piezoelectric element according to any one of claims 1 to 8, wherein a thickness of the lead zirconate titanate film is in the range of 0.1-5.0 $\mu$m.

10. The piezoelectric element according to any one of claims 1 to 9, wherein at the interface between the second electrode and the lead zirconate titanate film, a dielectric film composed of a dielectric having a dielectric constant lower than that of lead zirconate titanate constituting the lead zirconate titanate film is present, and the dielectric film and the lead zirconate titanate film have epitaxial relations such that (100) plane of the dielectric film and (100) plane of the lead zirconate titanate film are parallel.

11. The piezoelectric element according to claim 10, wherein the dielectric is lanthanum lead titanate.

12. The piezoelectric element according to claim 10 or 11, wherein a total thickness of the lead zirconate titanate film and the dielectric film is in the range of 0.1 to 5.0$\mu$m.

13. The piezoelectric element according to any one of claims 10 to 12, wherein a RMS value of surface roughness of the dielectric film at the side of the second electrode is 5.0nm or less.

14. The piezoelectric element according to any one of claims 1 to 13, wherein when the piezoelectric constant measured by grounding the first electrode and applying a voltage of 30V to the second electrode is A and the piezoelectric constant measured by applying a voltage of 10V to the second electrode is B, B is 95% or more of A.

15. A piezoelectric actuator comprising a piezoelectric element, wherein
the piezoelectric element is a piezoelectric element according to any one of claims 1 to 14.

16. A droplet discharge head comprising a piezoelectric actuator, wherein
the piezoelectric actuator is a piezoelectric actuator according to claim 15.

17. A liquid droplet ejection apparatus comprising a droplet discharge head, wherein

the droplet discharge head is a droplet discharge head according to claim 16.

18. A ferroelectric memory comprising a piezoelectric element, wherein
the piezoelectric element is a piezoelectric element according to any one of claims 1 to 14.

# FIG.1

# FIG.2

# FIG.3

# FIG.4

# FIG.5

# FIG.6

MEASURED VALUE
FITTING CURVE

# FIG.7

MEASURED VALUE
COMPONENT CURVE
FITTING CURVE

# FIG.8

# FIG.9

# FIG.10

# FIG.11

# FIG.12

# FIG.13

# FIG.14

# FIG.15

# FIG.16

Legend:
— MEASURED VALUE
—·—·— FITTING CURVE

# FIG.17

Height Sensor

20.0nm

1.0 μm

# FIG.18

40.0nm

Height Sensor

1.0 $\mu$ m

## EP 4 362 649 A1

**INTERNATIONAL SEARCH REPORT**

| International application No. |
|---|
| **PCT/JP2022/033376** |

### A. CLASSIFICATION OF SUBJECT MATTER

*H10N 30/853*(2023.01)i; *H10N 30/045*(2023.01)i; *H10N 30/076*(2023.01)i; *H10N 30/20*(2023.01)i
FI: H01L41/187; H01L41/09; H01L41/257; H01L41/316

According to International Patent Classification (IPC) or to both national classification and IPC

### B. FIELDS SEARCHED

Minimum documentation searched (classification system followed by classification symbols)

H01L41/187; H01L41/09; H01L41/257; H01L41/316

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2019-016793 A (ADVANCED MATERIAL TECHNOLOGIES CO., LTD.) 31 January 2019 (2019-01-31)<br>paragraphs [0056]-[0252], fig. 2 | 1, 5, 7-18 |
| A | | 2, 3, 4, 6 |
| Y | JP 2015-225957 A (RICOH CO., LTD.) 14 December 2015 (2015-12-14)<br>paragraphs [0050]-[0109], fig. 8, 10-13 | 1, 5, 7-18 |
| Y | JP 2008-522426 A (AGCY. FOR SCIENCE, TECHNOLOGY AND RESEARCH) 26 June 2008 (2008-06-26)<br>paragraphs [0002]-[0038], fig. 5 | 10-18 |
| A | JP 2017-112306 A (YUUTEKKU KK) 22 June 2017 (2017-06-22)<br>paragraphs [0036]-[0072], fig. 1, 2 | 1-18 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **17 November 2022** | **29 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

29

## INTERNATIONAL SEARCH REPORT
### Information on patent family members

International application No.

**PCT/JP2022/033376**

| Patent document cited in search report | | | Publication date (day/month/year) | Patent family member(s) | Publication date (day/month/year) |
|---|---|---|---|---|---|
| JP | 2019-016793 | A | 31 January 2019 | US 2019/0013459 A1 paragraphs [0095]-[0333], fig. 2 TW 201907030 A | |
| JP | 2015-225957 | A | 14 December 2015 | US 2015/0349240 A1 paragraphs [0085]-[0144], fig. 8, 10-13 | |
| JP | 2008-522426 | A | 26 June 2008 | US 2006/0118840 A1 paragraphs [0002]-[0051], fig. 5 WO 2006/059955 A1 | |
| JP | 2017-112306 | A | 22 June 2017 | US 2017/0179367 A1 paragraphs [0106]-[0143], fig. 1, 2 TW 201724589 A | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000091533 A

- JP 2019216181 A

**Non-patent literature cited in the description**

- **I. KANNO et al.** Piezoelectric properties of c-axis oriented Pb(Zr,Ti)O3 thin films. *APL,* 1997, vol. 70, 1378